**Europäisches Patentamt**

**European Patent Office**

**Office européen des brevets**

(11) Veröffentlichungsnummer: **0 217 158**
**A2**

(12) # EUROPÄISCHE PATENTANMELDUNG

(21) Anmeldenummer: 86112146.5

(22) Anmeldetag: 02.09.86

(51) Int. Cl.⁴: **C 30 B 11/03**
**C 30 B 29/60, C 30 B 29/06**
**C 30 B 11/10**

(30) Priorität: 04.09.85 DE 3531610

(43) Veröffentlichungstag der Anmeldung:
08.04.87 Patentblatt 87/15

(84) Benannte Vertragsstaaten:
BE DE FR GB IT NL SE

(71) Anmelder: Wacker-Chemitronic Gesellschaft für
Elektronik-Grundstoffe mbH
Johannes-Hess-Strasse 24
D-8263 Burghausen(DE)

(72) Erfinder: Stock, Horst, Dipl.-Phys.
Fraunhofer Strasse 5
D-8263 Burghausen(DE)

(72) Erfinder: Huber, Lothar
Bonifaz-Huber-Strasse 8
D-8263 Burghausen(DE)

(72) Erfinder: Priewasser, Georg
Athaler Strasse 39
A-5122 Ach(AT)

(54) Verfahren und Vorrichtung zur Herstellung von Siliciumstäben.

(57) Es wird ein Verfahren zur Herstellung von Siliciumstäben mit einer Kolumnarstruktur aus einkristallinen Kristallbezirken mit kristallographischer Vorzugsorientierung angegeben. Aus einem Siliciumreservoir wird schmelzflüssiges Silicium in eine Kristallisationskammer überführt, welche durch in Form des gewünschten Stabquerschnittes fugendicht angeordnete Rollen gebildet wird. Dort bildet das Silicium zunächst eine stabile Außenschale aus erstarrtem Material aus und wird, während es weiter durchkristallisiert, nach unten abgezogen und von den Rollen freigegeben. Wegen des kurzen Kontaktes mit einer Gefäßwandung wird ein besonders verunreinigungsarmer Siliciumstab erhalten.

EP 0 217 158 A2

Gesellschaft für Elektronik-
Grundstoffe mbH

CT 8403
=======

0217158

## Verfahren und Vorrichtung zur Herstellung von Siliciumstäben

Die Erfindung betrifft ein Verfahren zur Herstellung von Siliciumstäben mit Kolumnarstruktur aus einkristallinen Kristallbezirken mit kristallographischer Vorzugsorientierung durch kontinuierliches oder taktweises Überführen von schmelzflüssigem Silicium aus einem Siliciumreservoir in eine Kristallisationskammer, gerichtetes Erstarren des Siliciums unter Aufrechterhaltung eines überstehenden Schmelzsees und Abziehen des erstarrten Siliciums über eine abwärts bewegliche Unterlage, sowie eine Vorrichtung zur Durchführung des Verfahrens.

Bei diesem, aus der US-PS 4 312 700 bekannten Verfahrens besteht jedoch zwischen dem Schmelzsee bzw. dem erstarrenden Silicium und der angrenzenden, meist aus Graphit gefertigten Gefäßwandung sowie ggf. auch einer zusätzlich aufgebrachten dünnen Schicht einer Schutzschmelze ein enger und langer Kontakt, der eine Anreicherung von störenden Verunreinigungen, wie z.B. Kohlenstoff im Randbereich des abgezogenen Siliciumstabes zur Folge hat. Das erhaltene, verunreinigte Material besitzt eine gegenüber verunreinigungsfreiem Material geringere Qualität; beispielsweise haben daraus hergestellte Solarzellen einen merklich erniedrigten Wirkungsgrad. Oftmals ist es daher nötig, die verunreinigten seitlichen Randzonen des Siliciumstabes abzutrennen, um zu einem den Anforderungen entsprechenden Solarzellengrundmaterial zu kommen.

Aufgabe der Erfindung war es daher, ein Verfahren anzugeben, nach dem sich insbesondere als Solarzellengrundmaterial geeignete Siliciumstäbe in gegenüber dem genannten Stand der Technik erhöhter Reinheit und Qualität erhalten lassen.

Gelöst wird die Aufgabe durch ein Verfahren, welches dadurch
gekennzeichnet ist, daß das schmelzflüssige Silicium in eine
Kristallisationskammer überführt wird, in welcher der Schmelzsee in Form des gewünschten Stabquerschnittes von in Abziehrichtung drehbaren, zumindest an der mit schmelzflüssigem
Silicium in Kontakt kommenden Oberfläche aus gegenüber diesem weitgehend inertem Material bestehenden Rollen fugendicht umgeben ist, durch die das schmelzflüssige Silicium
formgebend eingeschlossen und erst nach Bildung zumindest
einer stabilen erstarrten Außenschale freigegeben wird.

Nach diesem Verfahren lassen sich insbesondere Siliciumstäbe
mit quadratischem oder rechteckigem Querschnitt herstellen,
wenngleich auch andere, z.B. prismen- oder polygonartige,
z.B. hexagonale Stabquerschnitte grundsätzlich nicht ausgeschlossen sind. Bewährt haben sich vor allem quadratische
Stabquerschnitte mit Kantenlängen von ca.100 mm bzw.ca. 200 mm
oder rechteckige mit ca.100 u.ca.200 mm Kantenlänge, aus denen
sich entweder direkt bzw. nach Auftrennung in Teilblöcke z.B. quadratische Scheiben von 100 x 100 mm² in der gewünschten Dicke,
meist 300 bis 500 µm, sägen und zu Solarzellen weiterverarbeiten lassen. Grundsätzlich sind auch andere Seitenlängen nicht
ausgeschlossen.
Die Kristallisationskammer wird durch Rollen gebildet, die in
einer Ebene so angeordnet sind, daß durch die von ihnen umgebene Durchtrittsfläche der gewünschte Stabquerschnitt festgelegt wird. Besondere Bedeutung kommt bei dieser Anordnung
dem Bereich der Ecken zu, in dem benachbarte Rollen aneinanderstoßen. Hier ist einerseits die Gefahr des Ausfließens des
in der Kristallisationskammer befindlichen schmelzflüssigen
Siliciums, andererseits die Gefahr der Bildung von störendem
Abrieb besonders groß. Bevorzugt werden daher die Rollen in
der Weise zueinander angeordnet, daß sie zwar unabhängig voneinander frei drehbar sind, daß aber dennoch der Abstand an
der engsten Stelle möglichst gering gehalten wird. Erfahrungsgemäß ist wegen der hohen Oberflächenspannung des schmelzflüssigen Siliciums bis zu einem Wert von etwa 0,5 mm gewährleistet, daß die Kristallisationskammer an der engsten Durchtrittsfläche fugendicht ist, d.h., daß an dieser Stelle kein Silicium austreten kann. Insbesondere hat sich eine Überlappung der Rollen im Randbereich, zweckmäßig über eine Länge von etwa 0,5 bis 5 mm, als günstig erwiesen. Es ist aber auch grundsätzlich nicht ausgeschlossen, die Rollen in Kontakt zueinander anzuordnen.

Als Werkstoff für die mit geschmolzenem Silicium in Kontakt kommende Oberfläche der Rollen kommen Materialien in Frage, die gegenüber diesem weitgehend inert sind, d.h. unter den Prozeßbedingungen nicht oder nur schwer angegriffen werden, und durch welche weiterhin das Silicium nicht in unzulässiger Weise verunreinigt wird. Solche Materialien sind beispielsweise bestimmte, z.B. durch Imporbeschichtung, inertisierte Graphitsorten, Glaskohle, Quarz oder reaktionsgebundenes oder heißgepreßtes Siliciumnitrid bzw. Siliciumcarbid. Dabei können die gesamten Rollen aus den genannten Materialien gefertigt sein; vielfach kann jedoch auch ein aus anderen Materialien, z.B. nicht inertisiertem Graphit, Edelstahl oder Kupfer gefertigter Rollengrundkörper mit einer Beschichtung versehen werden. Allgemein hat sich der Einsatz von Graphit als vorteilhaft erwiesen, beispielsweise in durch Imprägnieren mit einer organischen Verbindung und deren nachfolgende Zersetzung zu Kohlenstoff porendicht gemachter oder mit Siliciumcarbid und/oder Siliciumnitrid beschichteter Form. Eine Beschichtung mit Quarz kann z.B. in einfacher Weise dadurch erreicht werden, daß die Rollen mit einer Quarzschnur umwickelt werden.

Die Länge der Rollen richtet sich nach dem jeweils gewünschten Stabquerschnitt; sie entspricht also im wesentlichen der jeweiligen Seitenlänge des Stabes, welche ggf. um die überlappende Strecke verlängert ist. Die beim Erstarren von Silicium auftretende Volumenvergrößerung um ca. 10 % wirkt sich erfahrungsgemäß auf den Stabquerschnitt weniger stark als auf die Stabmitte aus, da die Erstarrungsfront in der Regel von den Seitenwänden ausgehend nach innen verläuft. Der Rollendurchmesser wird zweckmäßig im Bereich von 50 bis 200 mm, bevorzugt 80 bis 120 mm gewählt. In diesem Bereich weisen die Mantelflächen der Rollen eine Krümmung auf, die ein zuverlässiges Einschließen des überstehenden Schmelzsees gewährleistet und zugleich ein Verklemmen des erstarrten Siliciums an der engsten Stelle der Durchtrittsfläche verhindert. Grundsätzlich sind zwar größere oder kleinere Rollendurchmesser nicht ausgeschlossen, erfordern aber eine sehr genaue und daher aufwendige Einhaltung der Schmelzenhöhe, der Lage des Schmelzsees und der Kristallisationsfront bezüglich der Durchtrittsfläche.

Um die Temperatur des Schmelzsees und sein Erstarrungsverhalten zu steuern, hat es sich bewährt, Möglichkeiten zur Regulierung der Rollentemperatur vorzusehen. Beispielsweise können die Rollen von einem geeigneten Kühlmedium, z.B. einem Kühlgas wie Argon, durchströmt werden, um insbesondere bei längerer Dauer des Kristallisationsvorganges die Mantelfläche auf einer Temperatur unterhalb des Siliciumschmelzpunktes zu halten. In der Anfangsphase der Stabherstellung ist es jedoch oft von Vorteil, die Rollen mit Hilfe einer vorzugsweise externen Heizeinrichtung, z.B. durch Strahlungsheizung, vorzuheizen. Allgemein hat sich eine oberhalb 1000 °C, bevorzugt oberhalb 1350 °C und unterhalb der Schmelztemperatur des Siliciums liegende Oberflächentemperatur der Rollen als günstig erwiesen.

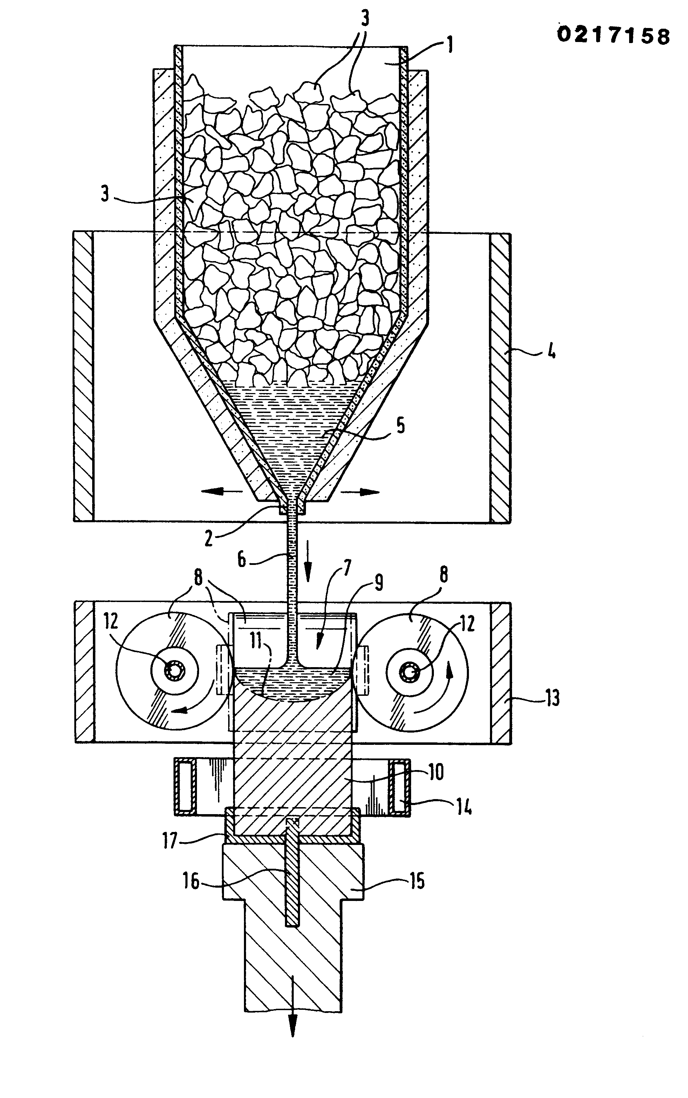

Das erfindungsgemäße Verfahren wird im folgenden anhand der Figur 1 näher erläutert, in der beispielhaft eine mögliche Ausführungsform einer Vorrichtung zur Durchführung des Verfahrens schematisch im Querschnitt dargestellt ist.

In einem Siliciumreservoir 1, welches beispielsweise in Form eines nach unten trichterförmig in einer Auslaßöffnung 2 endenden Schmelztiegels gestaltet sein kann, wird in geeigneter, z.B. stückiger, polykristalliner Form Silicium 3, ggf. unter Zusatz von Dotierstoffen, vorgelegt. Mit Hilfe einer Heizzone 4, welche beispielsweise mittels Widerstands-, induktiver oder Elektronenstrahlheizung erzeugt werden kann, wird das Silicium erhitzt, im unteren Tiegelbereich zum Aufschmelzen gebracht und sammelt sich als Schmelze 5 oberhalb der Auslaßöffnung 2. Bei dieser Anordnung läßt sich durch Erhöhung bzw. Verminderung der zugeführten Heizleistung in einfacher Weise die erzeugte Menge geschmolzenen Siliciums steuern.

Der Vorteil eines solcherart gestalteten Siliciumreservoirs liegt darin, daß es sich gleichermaßen für einen kontinuierlichen wie taktweisen Betrieb eignet, sowohl was das Nachchargieren des stückigen wie auch die Freigabe des schmelzflüssigen Siliciums anbetrifft.

Beim eigentlichen Aufschmelzvorgang wird vorteilhaft dem kontinuierlich oder portionsweise, beispielsweise mittels Schüttelrinne, in ein solches Siliciumreservoir chargierten stückigen Silicium die zum Aufschmelzen erforderliche Heizernergie in der Weise zugeführt, daß das über der Auslaßöffnung sich ansammelnde schmelzflüssige Silicium vor dem Ausfließen in Kontakt mit nachrückendem stückigem Silicium bleibt. In der Regel ist es daher ausreichend, den Schmelztiegel nicht über die gesamte Tiegelhöhe, sondern nur über eine etwa ein bis zwei Drittel seines unteren Bereiches umfassende Zone zu beheizen. Diese Anordnung gewährleistet durch das von oben nachrückende stückige und nach und nach zum Schmelzen kommende Silicium einen konstanten Materialnachschub in den Schmelzbereich und zugleich einen gleichmäßigen und von der Schmelzenhöhe weitgehend unabhängigen Abfluß des schmelzflüssigen Siliciums. Durch den dauernden Kontakt zwischen schmelzflüssigem und festem Silicium wird zugleich eine besonders homogen temperierte, konvektionsarme Schmelze erzeugt, aus der sich z.B. beim gerichteten Erstarren ein störungsarmes, hochwertiges Material gewinnen läßt. Da darüber hinaus das Silicium nur kurzzeitig, in geringer Menge und bei unwesentlicher Überhitzung in schmelzflüssiger Form vorliegt, ist auch der Anteil von durch Reaktion mit der Gefäßwandung eingeschleppten Verunreinigungen gering. Der Öffnungswinkel, mit dem sich von der Auslaßöffnung ausgehend der Schmelztiegel weitet,
bis die vorgesehene lichte Weite erreicht ist, beträgt
zweckmäßig 30 - 180 °, vorzugsweise 60 - 120 °. Gleichfalls
möglich sind andere, z.B. schüsselförmige Ausgestaltungen
des Schmelztiegelbodens, sofern sie das Nachrücken von
stückigem Silicium und die Ausbildung eines Schmelzsees gestatten. Auch der Innendurchmesser der Auslaßöffnung wird
günstig so groß gewählt, daß in der Zeiteinheit höchstens
die Menge schmelzflüssigen Siliciums abfließen kann, die
bei maximaler Heizleistung in der Zeiteinheit erzeugt wird.

Als Tiegelmaterial lassen sich grundsätzlich auch die für die
Rollen in Frage kommenden Werkstoffe verwenden; bevorzugt werden jedoch Quarztiegel eingesetzt, die in der Regel von einem
Stütztiegel aus Graphit und, zumindest in ihrem unteren Bereich, auch von einer Heizeinrichtung umgeben sind.

Durch die Auslaßöffnung 2 verläßt die Schmelze 5 in einem
Strahl 6 das Siliciumreservoir 1 und gelangt in die Kristallisationskammer 7, welche beispielsweise durch in Form eines
Quadrates angeordnete, drehbare Rollen 8 gebildet wird.

Für die Bereitstellung des geschmolzenen Siliciums in einem
Reservoir und die Überführung in die Kristallisationskammer
eignet sich beispielsweise auch die Methode der Dosierung mittels
Verdrängungskörper aus einem mit Siliciumschmelze gefüllten
Vorratsbehälter. Ebenso läßt sich z.B. ein Tiegel einsetzen,
bei dem das enthaltene schmelzflüssige Silicium vermöge einer
drehbaren, vertikal beweglichen Stopfenstange über eine in
seinem Boden ausgebildete, verschließbare Öffnung kontrolliert
freigegeben wird. In diesem Zusammenhang wird beispielsweise
auf die in der eingangs genannten US-PS 4 312 700 beschriebenen Methoden verwiesen. Auch ein sukzessives Abschmelzen
eines polykristallinen Siliciumstabes oder eines Stabes aus
kompaktiertem Siliciumgranulat mittels Elektronenstrahl ist
denkbar.

In der von den Rollen 8 seitlich fugendicht umgebenen Kristallisationskammer 7 bildet das zugeführte schmelzflüssige Silicium
einen Schmelzsee 9 aus, welcher den bereits erstarrten Siliciumstab 10 überschichtet. In dem Maße, wie die Kristallisationsfront 11 von den, vorteilhaft gekühlten, Rollen 8 und
dem bereits erstarrten Siliciumstab 10 ausgehend im Schmelzsee fortschreitet, wird der Siliciumstab 10 nach unten bewegt, so daß das neu gebildete erstarrte Silicium aus der
Kristallisationskammer 7 herausgeführt wird, während von oben aus dem
Siliciumreservoir 1 neues schmelzflüssiges Silicium zugegeben wird. Die
Kühlung der Rollen kann beispielsweise durch ein die Kühlkanäle 12 durchströmendes Kühlmedium wie etwa Argon erfolgen. Vorzugsweise wird der Stab in
vertikaler Richtung nach unten abgezogen, obwohl grundsätzlich auch andere von
der Vertikalen abweichende Richtungen nicht ausgeschlossen sind.

Beim Kristallisationsvorgang darf die Kristallisationsfront 11
in keinem Fall so weit absinken, daß der im Randbereich zwischen
der gekrümmten Mantelfläche der Rolle und dem bereits erstarrten Silicium sich bildende, durch die Oberflächenspannung gehaltene Schmelzenmeniskus abreißt und das schmelzflüssige
Silicium austreten kann. Erfahrungsgemäß liegt der Grenzwert
bei einer Breite des Meniskus von ca.0,5 bis 1,5 mm.Ebenso schädlich
ist jedoch auch ein Ansteigen der Kristallisationsfront 11 über
die engste Durchtrittsfläche zwischen den Rollen hinaus. Der
Siliciumstab kann dann nämlich mit einem zu großen Querschnitt
erstarren, könnte nicht mehr nach unten bewegt werden und
würde unweigerlich die Rollen blockieren.

Bevorzugt werden daher die Menge des in der Zeiteinheit zugeführten schmelzflüssigen und die des abgezogenen erstarrten
Siliciums so aufeinander abgestimmt, daß die Oberfläche des
Schmelzsees mit möglichst geringen Abweichungen auf der Höhe
der durch die Rollen bestimmten engsten Durchtrittsfläche
gehalten wird. In der Regel sind dabei Abweichungen um etwa
5 mm nach oben oder unten noch zulässig. Die Höhe des Schmelzsees, d.h. der Abstand zwischen der Kristallisationsfront und
der Schmelzenoberfläche, wird im Randbereich des Stabes
zweckmäßig auf einem Wert von 0,1 bis 5 mm gehalten, während im Inneren des Stabes auch höhere Werte, typisch bis zu
ca. der Hälfte der Seitenlänge, auftreten können.

Die Lage des Schmelzsees 9 innerhalb der Kristallisationskammer 7 kann beispielsweise mittels eines Pyrometers überwacht werden, welches auf die gewünschte Position der Schmelzenoberfläche an der Mantelfläche einer der Rollen gerichtet ist.
Sinkt die Schmelze ab, so erniedrigt sich auch die Temperatur
am Meßpunkt. Das Meßsignal kann beispielsweise an einen Impulsgeber weitergeleitet werden, der die Ziehgeschwindigkeit verlangsamt, mit welcher das erstarrte Silicium aus der Kristallisationskammer 7 abgezogen wird. Zusätzlich kann auch z.B. durch
Erhöhung der Heizleistung die aufgeschmolzene Menge im Siliciumreservoir 1 und damit der Zustrom schmelzflüssigen Siliciums erhöht werden, bis die vorgesehene Position der Schmelzenoberfläche wieder erreicht ist.

Steigt die Schmelze über das vorgesehene Niveau an, erhöht
sich also die Temperatur am Meßpunkt, so kann die Ziehgeschwindigkeit entsprechend gesteigert werden. Zusätzlich kann dann
ggf. noch die Heizleistung im Siliciumreservoir verringert und
so der Zustrom schmelzflüssigen Siliciums vermindert werden.

Vorteilhaft wird auch die Kühlung der Rollen, z.B. durch durchströmendes Argon, steuerbar ausgelegt, so daß selbst bei großen
Ziehgeschwindigkeiten und großer Schmelzenhöhe das schmelzflüssige Silicium im Kontaktbereich mit den Rollen durch starke Kühlung möglichst rasch zum Erstarren kommt. Auf diese Weise
kann gesichert werden, daß das schmelzflüssige Silicium nahezu unmittelbar nach dem Eindringen in die Kristallisationskammer 7 von einem Rand aus erstarrtem Silicium umgeben wird, der
ein Ausfließen verhindert und zugleich die Kontamination des
Siliciums durch Verunreinigungen aus den Rollen gering hält.
Die Dicke dieser sich rasch bildenden Randschicht kann durch
die Rollentemperatur gesteuert werden; allgemein hat sich eine
Dicke von 0,3 bis 1,0 mm bereits als ausreichend erwiesen. Um
einen Einfluß auf die Bildung der Randschicht zu haben, muß die Rollentemperatur naturgemäß unterhalb der Schmelztemperatur des Siliciums, vorzugsweise im Bereich von 1350 bis 1410 °C gehalten werden. Als zusätzliche Möglichkeit zur Steuerung der Rollentemperatur sowie, insbesondere in der Anfangsphase, auch der Temperatur innerhalb der Kristallisationskammer 7, wird vorteilhaft eine Heizvorrichtung 13 vorgesehen. Zu diesem Zweck kann beispielsweise ein die Kristallisationskammer 7 umgebender, nach außen isolierter, induktiv beheizter Graphitring eingesetzt werden.

Ein besonders günstiges Kristallisationsverhalten des in die Kristallisationskammer 7 überführten schmelzflüssigen Siliciums wurde gefunden, wenn der Strahl 6 nicht in einem über den gesamten Gießvorgang gleichen Bereich des Schmelzsees 9 auftrifft. Bevorzugt wird daher das schmelzflüssige Silicium in einem in seiner Richtung variierbaren Strahl in die Kristallisationskammer 7 überführt. Dadurch läßt sich der Strahl in verschiedene Bereiche der Oberfläche des Schmelzsees 9 lenken und kann so beispielsweise Unregelmäßigkeiten in der Erstarrungsfront und eine ungleichmäßige Temperaturverteilung im Schmelzsee 9, vor allem in den Rand- und Eckenbereichen, ausgleichen. So kann der Auftreffbereich beispielsweise in einer sternförmig in die Ecken weisenden, kreisenden oder bogenförmig von Ecke zu Ecke verlaufenden Bahn über die Oberfläche des Schmelzsees 9 gelenkt werden.

In einer Weiterbildung des Erfindungsgedankens ist vorgesehen, mittels geeigneter Meßeinrichtungen, z.B. Diodenarray, die Temperatur der Oberfläche des Schmelzsees 9 zu überwachen und über eine Steuereinrichtung den Strahl auf den jeweils kältesten Bereich zu richten.

Der Strahl kann beispielsweise durch Schwenken oder Verlagern des Siliciumreservoirs 1 auf den gewünschten Bereich des Schmelzsees 9 gelenkt werden. Gleichfalls möglich ist der Einsatz eines in den Strahl 6 eingebrachten, Richtungsänderungen gestattenden Organs, beispielsweise eines schwenk-oder verschiebbaren Trichters. Grundsätzlich ist zwar auch
eine Verschiebung der gesamten Kristallisationskammer 7 relativ zum Strahl 6 möglich, aber mit beträchtlichem apparativen
Aufwand verbunden.

Bei dem erfindungsgemäßen Verfahren lassen sich in der Regel
Ziehgeschwindigkeiten von 0,1 bis 30 mm/min, vorzugsweise
0,5 bis 5 mm/min erzielen. Bei der Einstellung bzw. Variation
der Ziehgeschwindigkeit ist darauf zu achten, daß das die
Kristallisationskammer 7 verlassende Silicium erst dann von
den Rollen 8 freigegeben wird, wenn sich zumindest eine stabile erstarrte Außenschale ausgebildet hat und ein Austreten von
schmelzflüssigem Silicium ausgeschlossen ist.

Vorteilhaft wird der aus der Kristallisationskammer 7 austretende Siliciumstab 10 vermittels einer Kühleinrichtung 14 zusätzlich gekühlt. Dafür kann beispielsweise ein Satz um den
Stab angeordneter Ringdüsen eingesetzt werden, aus denen ein
inertes Kühlgas, z.B. Argon, gegen den Stab geblasen wird.
Bevorzugt werden den Stab umgebende Kühlschlangen od. -körper aus
beispielsweise Edelstahl verwendet, die von einem geeigneten
Kühlmedium, insbesondere Wasser, durchströmt werden. Die Kühlung wird zweckmäßig dabei so eingestellt, daß der Siliciumstab in einem Abstand von etwa 30 bis 40 cm von der Kristallisationsfront eine Temperatur von etwa 700 bis 800 °C aufweist.
Der mittlere Temperaturgradient längs dieser Strecke sollte
etwa 5 bis 30 °C/cm betragen. Erfahrungsgemäß bereitet ab
einer Temperatur von etwa 600 bis 700 °C, wenn der plastische
Bereich unterschritten ist, die weitere Abkühlung keine
Schwierigkeiten mehr.

Die Bewegung des Siliciumstabes 10 nach unten wird durch die Unterlage 15 bewirkt, welche vorteilhaft von unten her, z.B.
durch ein durchströmendes Kühlmittel gekühlt ist und z.B.
mittels eines regelbaren, z.B. elektrischen oder hydraulischen Antriebs,
vorzugsweise vertikal nach oben bzw. unten gefahren werden kann und
somit die Ziehgeschwindigkeit bestimmt. Die Verbindung
zwischen Siliciumstab 10 und Unterlage 15 kann beispielsweise über einen in eine Ausnehmung in der Unterlage eingelassenen Siliciumkern    16 hergestellt werden,
der z.B. mit einem Bolzen gesichert und nach beendetem Ziehvorgang mitsamt dem erhaltenen Siliciumstab entfernt werden
kann.

Für den nachfolgenden Ziehvorgang kann dann in der Unterlage
15 ein neuer Siliciumkern    16 befestigt werden, der
zweckmäßig noch von einer vorzugsweise aus Quarzmaterial gefertigten Wanne 17 umgeben ist und günstig etwa 5 bis 20 mm
in deren Inneres hineinragt. Nun wird die Unterlage hochgefahren, zweckmäßig bis die Seitenwände der Wanne 17 in
Kontakt mit den Rollen kommen, und aus dem Siliciumreservoir
kann erneut schmelzflüssiges Silicium in die Kristallisationskammer überführt werden. Das anfänglich den Siliciumkern
16 umgebende schmelzflüssige Silicium verbindet sich beim Erstarren fest mit diesem und stellt auf diese Weise eine stabile Verbindung zwischen Siliciumstab und Unterlage her.

Der Ziehvorgang kann jedoch beispielsweise auch dadurch eingeleitet werden, daß eine mit der Unterlage 15 fest verbundene Impfkristallplatte entsprechender Größe an die Kristallisationskammer 7 herangeführt wird, bis diese nach unten dicht
geschlossen ist. Danach wird aus dem Siliciumreservoir 1 das
schmelzflüssige Silicium zugeführt und verbindet sich beim
Erstarren mit der Impfkristallplatte.

Wenn die vorgesehene Stablänge, typisch etwa 200 bis 1000 mm,
erreicht ist, wird, sofern nicht von vornherein eine entsprechende Siliciummenge vorgelegt wurde, die Siliciumzufuhr unterbrochen und der erhaltene Stab kann entnommen werden.Die Unterlage
15 wird dann für einen weiteren Ziehvorgang vorbereitet und
erneut an die Kristallisationskammer 7 herangefahren.

In einer Weiterbildung des Erfindungsgedankens ist vorgesehen, anstelle eines solchen semikontinuierlichen Verfahrens
in einem kontinuierlichen Ziehvorgang eine quasi endlose Säule aus der Kristallisationskammer zu ziehen, von der dann die Einzelstäbe der gewünschten Länge abgetrennt werden. Zu diesem Zweck lassen sich beispielsweise durch periodisches Einbringen von Trennplatten in die Kristallisationskammer in der erhaltenen Säule im gewünschten Abstand Sollbruchstellen schaffen, an denen die Verbindung dann, z.B. durch Brechen oder Sägen, aufgetrennt wird.

Für das erfindungsgemäße Verfahren eignen sich grundsätzlich die handelsüblichen bzw. in der Solartechnologie gebräuchlichen Siliciumsorten, sofern sie den sich aus dem gewünschten Produkt ergebenden Reinheitsanforderungen genügen. Ist das eingesetzte Material noch nicht dotiert oder weicht der Dotierstoffgehalt von der gewünschten Dotierung des Produktes ab, so kann beispielsweise im Siliciumreservoir die benötigte Dotierstoffmenge zugeschlagen werden. Bei Solarzellengrundmaterial wird dabei Bor oder Phosphor bevorzugt, obwohl grundsätzlich auch andere Dotierstoffe wie z.B. Aluminium, Gallium, Indium bzw. Arsen oder Antimon in Frage kommen. Gegebenenfalls können die Dotierstoffe auch mittels eines über den Schmelzsee 9 geleiteten, eine zersetzliche flüchtige Verbindung des Dotierstoffes, wie etwa Bor- oder Phosphorwasserstoff, enthaltenden Gasstromes zugeführt werden.

Die gesamte Anordnung wird in einem hier nicht dargestellten, zweckmäßig aus Edelstahl gefertigten, gasdichten Rezipienten untergebracht, um eine gegenüber Silicium inerte Arbeitsatmosphäre einstellen zu können. Dabei hat sich der Einsatz von Inertgasen wie Helium, Wasserstoff oder vorzugsweise Argon, vorteilhaft im Bereich von 1-100 mbar, bewährt.

Die nach dem erfindungsgemäßen Verfahren erhältlichen Siliciumstäbe mit Kolumnarstruktur aus einkristallinen Kristallbezirken mit kristallographischer Vorzugsorientierung lassen sich in der üblichen Weise in Scheiben zertrennen, die dann zu Solarzellen weiterverarbeitet werden. Die erhaltenen Scheiben zeichnen sich durch einen besonders geringen Gehalt an Verunreinigungen, insbesondere Kohlenstoff und Sauerstoff aus.

Das Verfahren wird nachstehend an einem Ausführungsbeispiel näher erläutert:

## Ausführungsbeispiel

Das Verfahren wurde in einer der Figur 1 entsprechenden Anordnung durchgeführt, bei der lediglich auf die Kühleinrichtung 14 verzichtet wurde. Die Apparatur war in einem vakuumdichten Rezipienten (Höhe ca. 800 mm, Durchmesser ca. 400 mm) untergebracht, in welchem nach vorherigem Evakuieren eine Argonatmosphäre mit einem Druck von etwa 10 mbar (Durchflußrate ca. 500 l Argon/h) eingestellt war.

Als Siliciumreservoir diente ein Quarztiegel (Höhe 480 mm, Durchmesser 200 mm, Wandstärke 5 mm), der von einem Stütztiegel aus Graphit gehalten war und in seinem unteren Drittel mittels eines umgebenden, nach außen isolierten, induktiv beheizten Graphitrohres beheizt werden konnte. Der Tiegel lief nach unten trichterförmig zu und endete in einer Auslaßöffnung mit ca 1 mm Durchmesser.

Mit Hilfe zweier im rechten Winkel zueinander wirkender Antriebsorgane konnte der Tiegel in der Ebene beliebig verschoben werden.

In ca. 300 mm Höhe befand sich im Rezipienten die Kristallisationskammer. Diese bestand aus 4 im Quadrat angeordneten Rollen aus durch Imprägnierung und Verdichtung gegenüber schmelzflüssigem Silicium inertisiertem Graphit mit 110 mm Länge und 100 mm Durchmesser. Die Rollen hatten an den Ecken einen Abstand von etwa 0,2 mm voneinander, waren also unabhängig voneinander frei drehbar und überlappten einander an den Ecken um ca. 2 mm, d.h. die von ihnen umgebene quadratische Durchtrittsfläche besaß eine Seitenlänge von ca. 108 mm. Die Rollen konnten durch Kanäle mit einem mittels eines Dosierventils regelbaren Argonstrom durchströmt und dadurch gekühlt werden. Die Kristallisationskammer mit den Rollen konnte durch ein sie umgebendes, nach außen isoliertes, induktiv beheizbares Graphitrohr (Höhe ca. 120 mm) aufgeheizt werden.

Von unten wurde mittels einer wassergekühlten, vertikal beweglichen Welle eine Unterlage, bestehend aus einem quadratischen Graphitboden (108 mm Seitenlänge) mit einer aufliegenden, den gleichen Querschnitt aufweisenden, aus Quarzmaterial gefertigten Wanne mit 20 mm Seitenhöhe, sowie einem mittels Bolzen in einer paßgerechten Ausnehmung des Bodens befestigten, rundstabförmigen Siliciumkern (Länge 150 mm, Durchmesser 12 mm), der durch den Wannenboden etwa 15 mm ins Innere der Wanne hineinragte, an die Kristallisationskammer herangefahren, bis die Wände der Wanne die Rollen berührten.

Das mit 4 kg stückigem Silicium befüllte Siliciumreservoir wurde aufgeheizt, das Silicium begann nach und nach aufzuschmelzen und floß durch die Auslaßöffnung in dünnem Strahl in die Kristallisationskammer. Mit Einsetzen des Siliciumflusses wurde das Siliciumreservoir aus seiner zentralen Ausgangsposition herausbewegt und beschrieb eine Umlaufbahn, aus welcher der Strahl bogenförmig von Ecke zu Ecke der Kristallisationskammer gelenkt wurde.

Während sich so die Wanne aus Quarzmaterial allmählich mit geschmolzenem Silicium füllte, erhöhte sich die mittels Pyrometer gemessene Temperatur der Rollen bis auf etwa 1400 °C und wurde mit Hilfe der Kristallisationskammerheizung und eines durch die Rollen geleiteten, variablen Argonstromes (Durchflußrate etwa 20 bis 300 l/h) auf diesem Wert gehalten. Dabei begann unter der Wirkung der umgebenden Schmelze auch der Siliciumkern eberflächlich anzuschmelzen, so daß sich bei deren erneutem Erstarren eine feste Verbindung zu der Unterlage ergab.

Als die Schmelzenoberfläche etwa 2 mm über die durch die Rollen gebildete engste Durchtrittsfläche angestiegen war, wurde die Unterlage mit einer mittleren Geschwindigkeit von ca. 3 mm/min abgesenkt. Damit entsprach die in der Zeiteinheit aus der Kristallisationskammer herausgeführte erstarrte Siliciummenge im wesentlichen der aus dem Siliciumreservoir zufließenden.

Während des Ziehvorganges wurde durch Variation der Ziehgeschwindigkeit und ggf. der Rollenkühlung die Schmelzenoberfläche stets im Bereich von etwa 2 mm ober- bis unterhalb der engsten Durchtrittsfläche gehalten. Dabei erstarrte das jeweils mit den gekühlten Rollen in Kontakt kommende schmelzflüssige Silicium sofort unter Ausbildung einer etwa 0,3 bis 1 mm dicken stabilen Außenschale, während zum Inneren zu die Kristallisation deutlich langsamer ablief, so daß letztendlich eine schüsselförmige Kristallisationsfront mit einem maximal etwa 30 mm tiefen Schmelzsee resultierte.

Als sich das Siliciumreservoir geleert hatte, wurde die Heizung der Kristallisationskammer zunächst kurz hochgefahren, um ein vorzeitiges Zuwachsen der Schmelzenoberfläche und ein Einschließen von geschmolzenem Material zu verhindern, und dann zum vollständigen Erstarren des Siliciums langsam abgestellt. Der erhaltene Stab der Maße 108 x 108 x 250 mm³ wurde auf etwa 500 °C abgekühlt und schließlich ausgeschleust. Er wies eine Kolumnarstruktur aus einkristallinen Kristallbezirken mit kristallographischer Vorzugsrichtung auf.

Nach Abtrennen einer ca. 4 mm starken Randzone wurde er in quadratische Scheiben (Seitenlänge 100 x 100 mm²) von 400 µm Dicke zersägt. Der durchschnittliche Kohlenstoffgehalt dieser Scheiben betrug $0.8 \cdot 10^{17}$ Atome C pro cm³, der Sauerstoffgehalt lag bei $2.4 \cdot 10^{17}$ Atomen O pro cm³.

P a t e n t a n s p r ü c h e

1. Verfahren zur Herstellung von Siliciumstäben mit Kolumnarstruktur aus einkristallinen Kristallbezirken mit kristallographischer Vorzugsrichtung durch kontinuierliches oder taktweises Überführen von schmelzflüssigem Silicium aus einem Siliciumreservoir in eine Kristallisationskammer, gerichtetes Erstarren des Siliciums unter Aufrechterhaltung eines überstehenden Schmelzsees und Abziehen des erstarrten Siliciums über eine abwärts bewegliche Unterlage, d a d u r c h g e k e n n z e i c h n e t , daß das schmelzflüssige Silicium in eine Kristallisationskammer überführt wird, in welcher der Schmelzsee in Form des gewünschten Stabquerschnittes von in Abziehrichtung drehbaren, zumindest an der mit schmelzflüssigem Silicium in Kontakt kommenden Oberfläche aus gegenüber diesem weitgehend inertem Material bestehenden Rollen fugendicht umgeben ist, durch die das schmelzflüssige Silicium formgebend eingeschlossen und erst nach Bildung zumindest einer stabilen erstarrten Außenschale freigegeben wird.

2. Verfahren nach Anspruch 1, d a d u r c h g e k e n n - z e i c h n e t , daß durch die Abstimmung der Menge des zugeführten schmelzflüssigen Siliciums und des abgezogenen erstarrten Siliciums die Oberfläche des Schmelzsees in einem bis zu 5 mm ober- oder unterhalb der durch die Rollen gebildeten engsten Durchtrittsfläche liegenden Bereich gehalten wird.

3. Verfahren nach den Ansprüchen 1 und 2, d a d u r c h g e k e n n z e i c h n e t , daß das schmelzflüssige Silicium in einem in seiner Richtung variierbaren Strahl in die Kristallisationskammer überführt wird.

4. Verfahren nach Anspruch 3, d a d u r c h   g e k e n n -
z e i c h n e t , daß der Strahl des schmelzflüssigen
Siliciums jeweils auf den kühlsten Teilbereich des
Schmelzsees gerichtet wird.

5. Verfahren nach einem oder mehreren der Ansprüche 1 bis 4,
d a d u r c h   g e k e n n z e i c h n e t , daß das
schmelzflüssige Silicium in einem mit stückigem Material
beschickten, nach unten in einem trichterförmigen Auslaß
zulaufenden Schmelztiegel erzeugt wird.

6. Verfahren nach einem oder mehreren der Ansprüche 1 bis 5,
d a d u r c h   g e k e n n z e i c h n e t , daß der
von den Rollen freigegebene erstarrte Stababschnitt gekühlt
wird.

7. Verfahren nach einem oder mehreren der Ansprüche 1 bis 6,
d a d u r c h   g e k e n n z e i c h n e t , daß die
Verbindung zwischen der abwärts beweglichen Unterlage und
dem erstarrten Silicium durch einen in der Unterlage fixierten, zu Beginn des Prozesses in den Schmelzsee ragenden
Siliciumabschnitt hergestellt wird.

8. Verfahren nach einem oder mehreren der Ansprüche 1 bis 7,
d a d u r c h   g e k e n n z e i c h n e t , daß die Rollen
auf einer Temperatur von 1200 bis 1410 °C gehalten werden.

9. Vorrichtung zur Durchführung des Verfahrens nach den Ansprüchen 1 bis 8, g e k e n n z e i c h n e t   d u r c h
ein zur Freigabe von schmelzflüssigem Silicium geeignetes
Siliciumreservoir, eine Kristallisationskammer, welche zur
Aufnahme von schmelzflüssigem Silicium geeignet und in Form
des gewünschten Stabquerschnittes von zumindest an der
Mantelfläche aus gegenüber schmelzflüssigem Silicium
inertem Material bestehenden, in Abziehrichtung drehbaren Rollen fugendicht umgeben ist, sowie eine abwärts bewegliche Unterlage, welche in ihren horizontalen Abmessungen
mindestens der Querschnittsfläche des herzustellendden
Stabes entspricht.

10. Verfahren zur Bereitstellung von schmelzflüssigem Silicium,
d a d u r c h  g e k e n n z e i c h n e t , daß in einem
trichterförmig nach unten zulaufenden und in einer Auslaßöffnung endenden Schmelztiegel kontinuierlich oder portionsweise chargiertes stückiges Silicium nach und nach in der
Weise aufgeschmolzen wird, daß das über der Auslaßöffnung
sich ansammelnde schmelzflüssige Silicium vor dem Ausfließen in Kontakt mit nachrückendem stückigem Silicium bleibt.